# EUROPEAN PATENT SPECIFICATION

(11) **EP 4 484 984 B1**
(45) Date of publication and mention of the grant of the patent: **23.09.2026**
(21) Application number: 23807734.1
(22) Date of filing: 27.01.2023
(51) Int. Cl.: G01R 31/396, G01R 31/392, G01R 31/3842, G01R 31/389, G01R 27/08, G01R 31/36, G01R 31/374

(54) **BATTERY DIAGNOSIS METHOD, AND BATTERY DIAGNOSIS DEVICE AND BATTERY SYSTEM FOR PROVIDING METHOD**
BATTERIEDIAGNOSEVERFAHREN UND BATTERIEDIAGNOSEVORRICHTUNG SOWIE BATTERIESYSTEM ZUR BEREITSTELLUNG DES VERFAHRENS
PROCÉDÉ DE DIAGNOSTIC DE BATTERIE ET DISPOSITIF DE DIAGNOSTIC DE BATTERIE ET SYSTÈME DE BATTERIE POUR FOURNIR UN PROCÉDÉ

(30) Priority: 20.05.2022 KR 20220061921
(43) Date of publication of application: 01.01.2025
(73) Proprietor: LG Energy Solution, Ltd., Seoul 07335 (KR)
(72) Inventor: KIM, Dong Hyun, Daejeon 34122 (KR)
(74) Representative: Plasseraud IP
(86) International application number: PCT/KR2023/001311
(87) International publication number: WO 2023/224209

(56) References cited:
- JP-A- 2006 098 135
- JP-A- 2018 096 744
- KR-A- 20150 029 204
- KR-A- 20190 035 441
- KR-A- 20220 030 824
- KR-A- 20220 030 824
- US-A1- 2008 169 819

## Description

### [Technical Field]

The present invention relates to a battery diagnosis method capable of diagnosing the states of batteries, and a battery diagnosis apparatus and a battery system for providing the method.

### [Background Art]

Large batteries to be mounted in electric vehicles, energy storage batteries, robots, satellites, and so on are required to be batteries having capacities higher than those of small batteries to be mounted in portable terminals, laptops, etc. High-capacity batteries may be configured by connecting a plurality of batteries in series and/or in parallel. In this case, the plurality of batteries may include a plurality of battery cells connected in parallel.

On the other hand, if the number of battery cells which are included in a battery increases, a defect may be caused in the battery by a battery cell's own problem and/or a connection problem between battery cells. For example, some defects such as a disconnection or a short between battery cells may occur. When a defect occurs in a battery, it is required to quickly diagnose and fix the defect such that a system including the battery (for example, a vehicle, an energy storage system, etc.) can be normally operated.

However, when a plurality of battery cells are connected in parallel, it is not easy to directly sense the cell voltages of the individual battery cells and so on because of the structural problems in the connection, etc. In other words, it is difficult to directly estimate battery cells' own defects in order to diagnose defects in the entire battery.

Further, a technique of diagnosing defects in batteries by estimating direct current internal resistance (DCIR) in each battery and comparing the estimated direct current internal resistance (DCIR) value with a predetermined (fixed) reference value has a limitation that it cannot detect defects when multiple battery cells in a battery are disconnected or short-circuited at the same time. Furthermore, a problem of misdiagnosing the degree of change in the direct current internal resistance value due to aging as a defect may occur. KR20220030824A relates to detecting a defect in a battery module based on internal resistance of the battery module.

### [Disclosure]

### [Technical Problem]

The present invention has been made in an effort to provide a battery diagnosis method having advantages of being able to accurately diagnose the state of a battery including a plurality of battery cells connected in parallel, and a battery system for providing the method.

### [Technical Solution]

An exemplary embodiment of the present invention provides a battery diagnosis apparatus including a measuring unit configured to measure a battery voltage, which is a voltage between both terminals of a battery and a battery current which is a current flowing through the battery, a storage unit configured to store a plurality of actual-measurement internal resistance values, each of which has been calculated based on at least one of the battery voltage and the battery current at each diagnosis time when diagnosing defects of the battery, and at least one test internal resistance value determined according to a predetermined criterion, and a control unit configured to extract a plurality of previous diagnosis times, corresponding to a predetermined number of samples, from each diagnosis time, at the diagnosis time, calculate a moving average, which is the average of a plurality of actual-measurement internal resistance values corresponding to the plurality of diagnosis times, respectively, and diagnose defects of the battery by comparing an actual-measurement internal resistance value calculated at each diagnosis time with reference values calculated based on the moving average, and wherein when the number of the extracted plurality of previous diagnosis times is less than the predetermined number of samples, the control unit calculates the moving average based on the plurality of actual-measurement internal resistance values and the test internal resistance values corresponding to the predetermined number of samples.

The reference values may include an upper band threshold larger than the moving average by a predetermined value, and a lower band threshold smaller than the moving average by a predetermined value.

The control unit may calculate an error value by multiplying a standard deviation average which is the average of a plurality of actual-measurement standard deviations corresponding to the plurality of diagnosis times, respectively, by a predetermined multiple, and calculate the upper band threshold by adding the error value to the moving average, and calculate the lower band threshold by subtracting the error value from the moving average.

The storage unit may further be configured to store actual-measurement standard deviations calculated at the individual diagnosis times, and at least one test standard deviation determined according to a predetermined criterion, and when the number of the extracted plurality of previous diagnosis times is less than the predetermined number of samples, the control unit may calculate the standard deviation average based on the actual-measurement standard deviations and the test standard deviations corresponding to the predetermined number of samples.

When the actual-measurement internal resistance value calculated at each diagnosis time exceeds the upper band threshold, the control unit may diagnose that a disconnection defect has occurred at at least one of a plurality of battery cells included in the battery.

When the actual-measurement internal resistance value calculated at each diagnosis time is smaller than the lower band threshold, the control unit may diagnose that a short defect has occurred at at least one of a plurality of battery cells included in the battery.

Another exemplary embodiment of the present invention provides a battery system including a battery that includes a plurality of battery cells, a measuring unit configured to measure a battery voltage, which is a voltage between both terminals of the battery and a battery current which is a current flowing through the battery, a storage unit configured to store a plurality of actual-measurement internal resistance values, each of which has been calculated based on at least one of the battery voltage and the battery current at each diagnosis time when diagnosing defects of the battery, and at least one test internal resistance value determined according to a predetermined criterion, and a control unit configured to extract a plurality of previous diagnosis times, corresponding to a predetermined number of samples, from each diagnosis time, at the diagnosis time, calculate a moving average, which is the average of a plurality of actual-measurement internal resistance values corresponding to the plurality of diagnosis times, respectively, and diagnose defects of the battery by comparing an actual-measurement internal resistance value calculated at each diagnosis time with reference values calculated based on of the moving average, and wherein when the number of the extracted plurality of previous diagnosis times is less than the predetermined number of samples, the control unit calculates the moving average based on the plurality of actual-measurement internal resistance values and the test internal resistance values corresponding to the predetermined number of samples.

The reference values may include an upper band threshold larger than the moving average by a predetermined value, and a lower band threshold smaller than the moving average by a predetermined value.

The control unit may further calculate an error value by multiplying a standard deviation average which is the average of a plurality of actual-measurement standard deviations corresponding to the plurality of diagnosis times, respectively, by a predetermined multiple, and calculate the upper band threshold by adding the error value to the moving average, and calculate the lower band threshold by subtracting the error value from the moving average.

The storage unit may be further configured to store the actual-measurement standard deviations calculated at the individual diagnosis times, and at least one test standard deviation determined according to a predetermined criterion, and when the number of the extracted plurality of previous diagnosis times is less than the predetermined number of samples, the control unit may calculate the standard deviation average based on the actual-measurement standard deviations and the test standard deviations corresponding to the predetermined number of samples.

When the actual-measurement internal resistance value calculated at each diagnosis time exceeds the upper band threshold, the control unit may diagnose that a disconnection defect has occurred at at least one of the plurality of battery cells.

When the actual-measurement internal resistance value calculated at each diagnosis time is smaller than the lower band threshold, the control unit may diagnose that a short defect has occurred at at least one of the plurality of battery cells.

Yet another exemplary embodiment of the present invention provides a battery diagnosis method including steps of collecting measurement values of each of battery voltage, which is a voltage between both terminals of a battery and a battery current which is the current flowing through the battery, determining a sample set by extracting a plurality of previous diagnosis times corresponding to a predetermined number of samples from a predetermined diagnosis time when diagnosing defects of the battery, calculating a moving average which is the average of a plurality of actual-measurement internal resistance values corresponding to the plurality of diagnosis times belonging to the sample set, respectively, and calculating reference values, which are references for diagnosing defects of the battery, based on the moving average, and diagnosing defects of the battery by comparing an actual-measurement internal resistance value corresponding to the predetermined diagnosis time with the reference values, wherein when the number of the extracted plurality of previous diagnosis times is less than the predetermined number of samples, the calculating the reference values calculates the moving average based on the plurality of actual-measurement internal resistance values and test internal resistance values corresponding to the predetermined number of samples, and at each diagnosis time, the actual-measurement internal resistance value is calculated based on at least one of the battery voltage and the battery current, and the test internal resistance values are determined according to a predetermined criterion.

The reference values may include an upper band threshold larger than the moving average by a predetermined value, and a lower band threshold smaller than the moving average by a predetermined value.

The calculating the reference values may further include calculating an error value by multiplying a standard deviation average which is the average of a plurality of actual-measurement standard deviations corresponding to the plurality of diagnosis times, respectively, by a predetermined multiple, and calculating the upper band threshold by adding the error value to the moving average, and calculating the lower band threshold by subtracting the error value from the moving average.

The calculating the reference values may further include calculating the standard deviation average based on actual-measurement standard deviations and test standard deviations corresponding to the predetermined number of samples, when the number of the extracted plurality of previous diagnosis times is less than the predetermined number of samples, and at each diagnosis time, the actual-measurement standard deviation may be calculated based on the plurality of actual-measurement internal resistance values corresponding to the predetermined number of samples, and the test standard deviations may be determined according to a predetermined criterion.

The calculating the reference values may further include calculating the moving average based on the test internal resistance values corresponding to the predetermined number of samples when the plurality of previous diagnosis times does not exist.

The diagnosing defects of the battery may include diagnosing that a disconnection defect has occurred at at least one of a plurality of battery cells included in the battery, when the actual-measurement internal resistance value calculated at each diagnosis time exceeds the upper band threshold.

The diagnosing defects of the battery may include diagnosing that a short defect has occurred at at least one of a plurality of battery cells included in the battery, when the actual-measurement internal resistance value calculated at each diagnosis time is smaller than the lower band threshold.

### [Advantageous Effects]

The present invention can accurately diagnose defects of batteries even when a plurality of battery cells is connected in parallel.

Unlike the prior art of diagnosing defects of batteries using fixed reference values, at each diagnosis time of diagnosing defects of a battery, the present invention sets reference values reflecting a change in the internal resistance value of the battery, to diagnose defects of the battery. Therefore, it is possible to prevent the problems of misdiagnosing an increase in the internal resistance value of a battery attributable to aging as a defect of the battery or misdiagnosing a temporary increase in the internal resistance value as a defect of the battery.

Even when there are not previous diagnosis times corresponding to the number of samples, the present invention can calculate reference values on the basis of a plurality of internal resistance values and a plurality of standard deviations stored in advance in a storage unit, thereby capable of accurately diagnosing defects of a battery even at an initial diagnosis time.

### [Description of the Drawings]

FIG. 1 is a drawing for explaining a battery diagnosis apparatus according to an exemplary embodiment.
FIG. 2 is a drawing for explaining a battery system according to another exemplary embodiment.
FIG. 3 is a drawing illustrating an example of a cumulative display of moving averages, upper band thresholds, and lower band thresholds calculated at a plurality of diagnosis times, respectively.
FIG. 4 is a flow chart for explaining a battery diagnosis method according to an exemplary embodiment.
FIG. 5 is a flow chart for explaining the sample-set determining step S200 of FIG. 4 in detail.
FIG. 6 is a flow chart for explaining the reference-value determining step S300 of FIG. 4 in detail.
FIG. 7 is a flow chart for explaining the defect diagnosis step S400 of FIG. 4 in detail.

### [Mode for Invention]

Hereinafter, exemplary embodiments disclosed in this specification will be described in detail with reference to the accompanying drawings; however, the same or similar constituent components are denoted by the same or similar reference symbols, and a repeated description thereof will not be made. As used herein, the suffix 'module' and/or the suffix 'unit' for constituent elements are given and used interchangeably in consideration of only ease of preparing this specification, and the suffixes themselves do not have meanings or roles distinguishable from each other. Further, when describing exemplary embodiments disclosed in this specification, detailed descriptions of publicly known technologies will be omitted.

Furthermore, the accompanying drawings are provided for helping to easily understand exemplary embodiments disclosed in the present specification, and it will be appreciated that the present invention includes all of the modifications, and substitutes included in the scope of the present invention.

Terms including an ordinal number, such as first and second, are used for describing various constituent elements, but the constituent elements are not limited by the terms. The terms are used only to discriminate one constituent element from another constituent element.

When a constituent element is referred to as being "connected" or "coupled" to another constituent element, it will be appreciated that it may be directly connected or coupled to the other constituent element or intervening other constituent elements may be present. In contrast, when a constituent element is referred to as being "directly connected" or "directly coupled" to another constituent element, it will be appreciated that there are no intervening other constituent elements present.

In the present application, it will be appreciated that terms "including" and "having" are intended to designate the existence of characteristics, numbers, steps, operations, constituent elements, and components described in the specification or a combination thereof, and do not exclude a possibility of the existence or addition of one or more other characteristics, numbers, steps, operations, constituent elements, and components, or a combination thereof in advance.

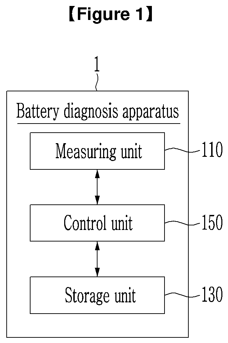

FIG. 1 is a drawing for explaining a battery diagnosis apparatus according to an exemplary embodiment.

Referring to FIG. 1, a battery diagnosis apparatus 1 includes a measuring unit 110, a storage unit 130, and a control unit 150.

The measuring unit 110 may measure a battery voltage which is the voltage between both terminals of a battery, a battery current which is a current flowing through a battery, and so on. Battery voltages and battery currents may be battery data required to calculate the internal resistance of batteries. For example, internal resistance may include direct current internal resistance (DCIR).

The measuring unit 110 may include a voltage sensor (not shown in the drawings) which is electrically connected between both terminals of a battery and measures the battery voltage, and a current sensor (not shown in the drawings) which is connected to a battery in series and measures the battery current. For example, at each diagnosis time of diagnosing defects of a battery, the measuring unit 110 may measure the battery voltage and the battery current, and transmit the measurement results to the control unit 150.

At each diagnosis time of diagnosing defects of a battery, the control unit 150 may use at least one of the battery voltage and the battery current to calculate an internal resistance value, which may be stored in the storage unit 130. Also, at each diagnosis time of diagnosing defects of a battery, the control unit 150 may store a battery voltage value and a battery current value received from the measuring unit 110, in the storage unit 130.

According to the exemplary embodiment, the storage unit 130 may store internal resistance values and standard deviations corresponding to a plurality of test diagnosis times determined according to a predetermined criterion, respectively. In this case, test diagnosis times may not be actual diagnosis times of diagnosing defects of a battery 10. Test diagnosis times may be theoretical diagnosis times including experimental values and so on. Specifically, test diagnosis times may be diagnosis times which are complementally provided when the number of actual-measurement diagnosis times is smaller than the number of samples constituting a sample set to be described below. Therefore, test diagnosis times may be stored in the storage unit 130 in association with internal resistance values and standard deviations which are provided to calculate moving averages MA, upper band thresholds UB_Th, and lower band thresholds LB_Th to be described below.

When a diagnosis time (N) according to a predetermined condition comes, the control unit 150 calculates a moving average MA, an upper band threshold UB_Th larger than the moving average by a predetermined value, a lower band threshold LB_Th smaller than the moving average by a predetermined value, and an internal resistance value corresponding to the diagnosis time (N).

According to the exemplary embodiment, a time when charging of a battery starts, or a time when discharging of a battery ends may be a diagnosis time (N) of diagnosing defects of the battery. When a diagnosis time (N) comes, the measuring unit 110 may measure a battery voltage and a battery current at intervals of a predetermined time for a predetermined period, and transmit the measurement results to the control unit 150.

First, the control unit 150 may determine a sample set by extracting a plurality of diagnosis times which is included in the predetermined number of samples SN when counting diagnosis times from the current diagnosis time (N) toward the previous diagnosis times. At this time, the number of samples SN may be the number of a plurality of diagnosis times which is included in a sample set, and be set to an optimal number based on experiments and so on. A sample set may be a set of some of a plurality of past diagnosis times constituting a population, and be a set for calculating a moving average MA, a standard deviation average σ_ave, and so on to be described below.

Hereinafter, Table 1 is an example of internal resistance (DCIR) values, moving averages MA, upper band thresholds UB_Th, and lower band thresholds LB_Th calculated at a plurality of diagnosis times, respectively. It is assumed that the number of samples SN is 5.

**(Table 1)**

| Diagnosis Interval | 1 | ... | N-7 | N-6 | N-5 | N-4 | N-3 | N-2 | N-1 | N |
|---|---|---|---|---|---|---|---|---|---|---|
| Internal Resistance (DCIR) | | ... | 25 | 27 | 23 | 24 | 20 | 21 | 23 | ① |
| Moving Average (MA) | | ... | 22.5 | 21 | 22 | 23.5 | 23 | 22 | 24 | ② |
| Standard Deviation (σ) | | ... | 1.56 | 1.60 | 1.70 | 1.60 | 1.82 | 1.73 | 1.63 | ③ |
| Standard Deviation Average (σ_ave) | | ... | 1.55 | 1.62 | 1.65 | 1.62 | 1.70 | 1.65 | 1.55 | ④ |
| Upper Band Threshold (UB_Th) | | ... | 27.15 | 26.20 | 26.95 | 27.90 | 28.1 | 26.95 | 28.65 | ⑤ |
| Lower Band Threshold (LB_Th) | | ... | 17.85 | 15.8 | 17.05 | 19.1 | 17.9 | 17.05 | 19.35 | ⑥ |
| Diagnosis Result | | ... | Normal | Abnormal | Normal | Normal | Normal | Normal | Normal | ⑦ |

For reference, in Table 1, the moving average MA, the standard deviation σ, the standard deviation average σ_ave, the upper band threshold UB_Th, and the lower band threshold LB_Th at the initial diagnosis time (1) may be difficult to be directly calculated (For this reason, the cells in Table 1 corresponding to those values are shown as blank), and the moving averages MA, the standard deviations σ, the standard deviation averages σ_ave, the upper band thresholds UB_Th, and the lower band thresholds LB_Th at diagnosis times (2, 3, ...) close to the initial diagnosis time (1) may also be difficult to be directly calculated since there is none or a lack of past diagnosis values for calculation. In this case, values which are calculated on average according to experiments may substitute for the moving averages MA, the standard deviations σ, the standard deviation averages σ_ave, the upper band thresholds UB_Th, and the lower band thresholds LB_Th at the early diagnosis times (2, 3, ...). The following Table 2 is an example thereof.

**(Table 2)**

| | | | | | |
|---|---|---|---|---|---|
| Diagnosis Interval | -5 | -4 | -3 | -2 | -1 |
| Internal Resistance (DCIR) | 25 | 27 | 23 | 24 | 20 |
| Moving Average (MA) | 22.5 | 21 | 22 | 23.5 | 23 |
| Standard Deviation (σ) | 1.56 | 1.60 | 1.70 | 1.60 | 1.82 |
| Standard Deviation Average (σ_ave) | 1.55 | 1.62 | 1.65 | 1.62 | 1.70 |
| Upper Band Threshold (UB_Th) | 27.15 | 26.20 | 26.95 | 27.90 | 28.1 |
| Lower Band Threshold (LB_Th) | 17.85 | 15.8 | 17.05 | 19.1 | 17.9 |
| Diagnosis Result | - | - | - | - | - |

In Table 2, the minus fifth to minus first diagnosis times (-5, -4, -3, -2, and -1) may be test diagnosis times described above. Internal resistance values and standard deviations, which correspond to the minus fifth to minus first diagnosis times, respectively, may be calculated experimentally, or may be calculated on the basis of the averages of the internal resistance values and standard deviations of a plurality of batteries having the same performance.

The diagnosis times disclosed in Table 1 may be defined as actual-measurement diagnosis times, and the internal resistance values, standard deviations corresponding to the actual-measurement diagnosis times may be described as actual-measurement internal resistance values and actual-measurement standard deviations. Also, the internal resistance values and the standard deviations shown in the above Table 2 and corresponding to the test diagnosis times may be described as test internal resistance values and test standard deviations.

For example, referring to Table 1 and Table 2, at the first diagnosis time (1), there is no previous actual-measurement diagnosis times corresponding to the number of samples SN. The control unit 150 may calculate a moving average MA1 (23.8) on the basis of a plurality of test internal resistance values (25, 27, 23, 24, and 20) corresponding to the minus fifth to minus first diagnosis times (-5, -4, -3, -2, and -1) which are test diagnosis times, respectively. Further, the control unit 150 may calculate a standard deviation average σ1_ave (1.656) on the basis of a plurality of test standard deviations (1.56, 1.60, 1.70, 1.60, and 1.82) corresponding to the minus fifth to minus first diagnosis times (-5, -4, -3, -2, and -1) which are test diagnosis times, respectively.

For another example, referring to Table 1 and Table 2, at the third diagnosis time (3), there is a lack of previous actual-measurement diagnosis times corresponding to the number of samples SN. In Table 1, internal resistance values and standard deviations corresponding to the first diagnosis time and the second diagnosis time, respectively, are not disclosed; however, it is assumed that they are disclosed. In the same way as described above, the control unit 150 may calculate a moving average MA3 and a standard deviation average σ3_ave on the basis of the internal resistance values and the standard deviations corresponding to the minus third to minus first diagnosis times (-3, -2, and -1) which are test diagnosis times and the first and second diagnosis times (1 and 2) which are actual-measurement diagnosis times, respectively.

Hereinafter, for ease of explanation, the actual-measurement diagnosis times, the actual-measurement internal resistance, the actual-measurement standard deviations, and so on disclosed in Table 1 will be described as diagnosis times, internal resistance, standard deviations, and so on. However, in order to distinguish between Table 1 and Table 2, in the case of the test diagnosis times disclosed in Table 2, the internal resistance, the standard deviations, and so on will be described as test internal resistance, test standard deviations, and so on.

Referring to Table 1, the control unit 150 may extract the (N-1)-th diagnosis time, the (N-2)-th diagnosis time, the (N-3)-th diagnosis time, the (N-4)-th diagnosis time, and the (N-5)-th diagnosis time corresponding to 5 which is the number of samples SN when counting diagnosis times from the current diagnosis time (N) toward the previous diagnosis times, to determine a sample set.

The control unit 150 may determine a sample set by extracting the plurality of diagnosis times (N-5, N-4, N-3, N-2, and N-1), and determine reference values (an upper band threshold and a lower band threshold to be described below) to be used for defect diagnosis, on the basis of the internal resistance values calculated at each of the plurality of diagnosis times included in the sample set. Then, it is possible to solve the problem of misdiagnosing the degree of aging according to long-term use of a battery and/or a temporary change in the internal resistance value as a defect of the battery.

Subsequently, the control unit 150 determines reference values (an upper band threshold and a lower band threshold) for diagnosing defects of the battery at the N-th diagnosis time, on the basis of the internal resistance values calculated at each of the plurality of diagnosis times (N-5, N-4, N-3, N-2, and N-1) belonging to the sample set.

According to the exemplary embodiment, the control unit 150 compares the internal resistance (DCIR) value corresponding to the N-th diagnosis time with the upper band threshold UB_Th and the lower band threshold LB_Th to diagnose defects of the battery. For example, referring to Table 1, at the N-th diagnosis time, the control unit 150 calculates the internal resistance value (①), the upper band threshold (⑤), and the lower band threshold (⑥), and compares the calculated internal resistance value (①) with the upper band threshold (⑤) and the lower band threshold (⑥) to diagnose defects of the battery. At this time, in order to calculate the upper band threshold (⑤) and the lower band threshold (⑥), the moving average (②) and the standard deviation average (④) are required. However, the standard deviation (③) is not a value necessary during defect diagnosis at the N-th diagnosis time; however, since it is necessary during defect diagnosis at the subsequent diagnosis times (N+1, N+2, ···), it may be calculated at the N-th diagnosis time and be stored in the storage unit 130. Hereinafter, the internal resistance value (①), the moving average (②), the standard deviation (③), the standard deviation average (④), the upper band threshold (⑤), and the lower band threshold (⑥) in Table 1 which the control unit 150 calculates at the N-th diagnosis time will be described.

The control unit 150 may calculate an internal resistance (DCIR_{N}) value corresponding to the N-th diagnosis time, on the basis of a battery voltage which is the voltage between both terminals of a battery and a battery current which is the current flowing through the battery. For example, the internal resistance (DCIR_{N}, ①) value may be calculated by the following Equation 1: $DCI {R}_{N} = \frac{Δ V}{I}$

For example, the control unit 150 may calculate the voltage difference between a battery voltage V1 corresponding to a first time when charging starts and a battery voltage V2 corresponding to a second time that is a predetermined time later from the first time ( ΔV = | V1 - V2|). The control unit 150 may calculate the internal resistance (DCIR_{N}) value on the basis of the charging current I flowing through the battery and the voltage difference ΔV. For example, it is assumed that 30Ω is calculated as the internal resistance (DCIR_{N}) value corresponding to the N-th diagnosis time.

Referring to Table 1, the control unit 150 may calculate a moving average MA_{N} (②) corresponding to the diagnosis time (N) by averaging the plurality of internal resistance values (23Ω, 24Ω, 20Ω, 21Ω, and 23Ω) corresponding to the plurality of diagnosis times (N-5, N-4, N-3, N-2, and N-1) belonging to the sample set ((23Ω + 24Ω + 20Ω + 21Ω + 23Ω) / 5 = 22.2 Ω). In other words, the internal resistance (DCIR_{N}) value corresponding to the N-th diagnosis time may be 22.2Ω. ${MA}_{N} = \frac{{DCIR}_{N - 5} + {DCIR}_{N - 4} + {DCIR}_{N - 3} + {DCIR}_{N - 2} + {DCIR}_{N - 1}}{SN}$

Referring to the following Table 3, the control unit 150 may calculate a standard deviation σ_{N} (③) corresponding to the diagnosis time (N), on the basis of the internal resistance values (DCIR) and the moving averages MA corresponding to the plurality of diagnosis times (N-5, N-4, N-3, N-2, and N-1) belonging to the sample set, respectively.

**(Table 3)**

| | N-5 | N-4 | N-3 | N-2 | N-1 | N |
|---|---|---|---|---|---|---|
| Internal Resistance (DCIR) | 23 | 24 | 20 | 21 | 23 | |
| \|DCIR-MA\| | \|23-22.2\| =0.8 | \|24-22.2\| =1.8 | \|20-22.2\| =2.2 | \|21-22.2\| =1.2 | \|23-22.2\| =0.8 | |
| (DCIR-MA)² | (0.8)² = 0.64 | (1.8)² = 3.24 | (2.2)² = 4.84 | (1.2)² = 1.44 | (0.8)² = 0.64 | |
| Dispersion | (0.64 + 3.24 + 4.84 + 1.44 + 0.64) / 5 = 2.16 | | | | | |
| Standard Deviation (σ_{N}) | $\sqrt{2.16} = 1.4696938457 \left(\approx 1.47\right)$ | | | | | 1.47 |

As described above, the standard deviation σ_{N} (③) corresponding to the diagnosis time (N) is not a value necessary for defect diagnosis at the N-th diagnosis time, but is necessary for defect diagnosis at the subsequent diagnosis times (N+1, N+2. ···). Therefore, the standard deviation σ_{N} (③) corresponding to the diagnosis time (N) may be calculated at the N-th diagnosis time and be stored in the storage unit 130.

Referring to the following Table 4, the control unit 150 may calculate the standard deviation average σ_{N_ave} (④) corresponding to the diagnosis time (N), on the basis of the plurality of standard deviations (σ_{N-5}, σ_{N-4}, σ_{N-3}, σ_{N-2}, and σ_{N-1}) corresponding to the plurality of diagnosis times (N-5, N-4, N-3, N-2, and N-1) belonging to the sample set, respectively.

**(Table 4)**

| | N-5 | N-4 | N-3 | N-2 | N-1 | N |
|---|---|---|---|---|---|---|
| Standard Deviation (σ) | 1.70 | 1.60 | 1.82 | 1.73 | 1.63 | |
| Standard Deviation Average (σ_{N_ave}) | (1.70 + 1.60 + 1.82 + 1.73 + 1.63) / 5 = 1.696 | | | | | 1.70 |

The control unit 150 may calculate an upper band threshold UB_{N}_TH larger than the moving average MA_{N} by a predetermined value, and a lower band threshold LB_{N_}TH smaller than the moving average MA by a predetermined value. According to the exemplary embodiment, the control unit 150 may calculate a first error value by multiplying the standard deviation average σ_{N_ave} by a predetermined first multiple and calculate an upper band threshold UB_{N_}TH by adding the first error value to the moving average MA_{N}. Also, the control unit 150 may calculate a second error value by multiplying the standard deviation average σ_{N_ave} by a predetermined second multiple, and calculate a lower band threshold LB_{N_}TH by subtracting the second error value from the moving average MA_{N}. In this case, the first multiple and the second multiple may be the same, but are not limited thereto, and may be set to various multiples.

According to the exemplary embodiment, the control unit 150 may calculate an error value E (= σ_{N_ave} × Q) by multiplying the standard deviation average σ_{N_ave} which is the average of the standard deviations of the sample set and a predetermined multiple Q together. In this case, the multiple Q may be a value for reflecting a predetermined error, and may be set to various values by experiments. For example, it is assumed that the multiple Q is a natural number 3.

The control unit 150 may calculate an upper band threshold (UB_{N_}Th) 27.3 by adding the error value E (= σ_{N_ave} × Q = 1.70 × 3 = 5.1) to the moving average MA_{N} (= 22.2) of the sample set, as shown in the following Equation 3. Also, the control unit 150 may calculate a lower band threshold (LB_{N_}Th) 17.1 by subtracting the error value E (= σ_{N_ave} × Q = 1.70 × 3 = 5.1) from the moving average MA_{N} (= 22.2) of the sample set, as shown in the following Equation 4. ${UB}_{N _} Th = {MA}_{N} + \left({σ}_{N _}ave X Q\right)$ ${LB}_{N _} Th = {MA}_{N} - \left({σ}_{N _}ave X Q\right)$

Subsequently, the control unit 150 may diagnose defects of the battery by comparing the internal resistance (DCIR_{N}) value corresponding to the N-th diagnosis time with the upper band threshold UB_{N}_Th and the lower band threshold LB_{N_}Th corresponding to the N-th diagnosis time.

According to the exemplary embodiment, when the internal resistance (DCIR_{N}) value exceeds the upper band threshold UB_{N}_Th, the control unit 150 may diagnose that a disconnection defect DD has occurred at at least one of the plurality of battery cells included in the battery. When the internal resistance (DCIR_{N}) value is smaller than the lower band threshold LB_{N}_Th, the control unit 150 may diagnose that a short defect SD has occurred at at least one of the plurality of battery cells included in the battery. In other words, when the internal resistance (DCIR_{N}) value is out of a normal range from the lower band threshold LB_{N}_Th to the upper band threshold UB_{N}_Th, the control unit 150 may diagnose that a defect (a disconnection defect or a short defect) has occurred in the battery. Also, when the internal resistance (DCIR_{N}) value is in the normal range, the control unit 150 may diagnose that the state of the battery is normal.

For example, as described above through Table 1, Table 4, and Equation 1 to Equation 4, 30 (Ω), 27.3, and 17.1 may be calculated as the internal resistance (DCIR_{N}) value, the upper band threshold UB_{N_}Th, and the lower band threshold LB_{N_}Th corresponding to the N-th diagnosis time, respectively. In this case, since the internal resistance value (DCIR_{N} = 30) exceeds the upper band threshold (UB_{N_}Th = 27.3), the control unit 150 may diagnose a disconnection defect of the battery.

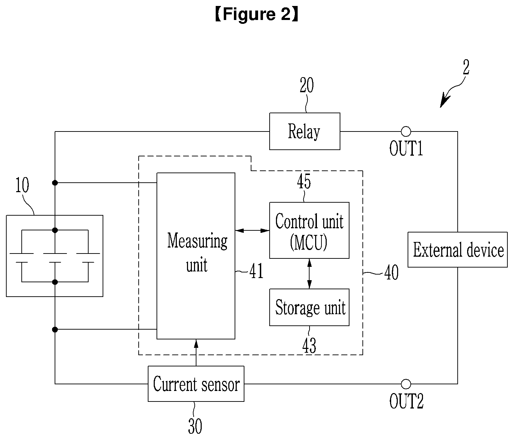

FIG. 2 is a drawing for explaining a battery system according to another exemplary embodiment.

Referring to FIG. 2, a battery system 2 includes a battery 10, a relay 20, a current sensor 30, and a battery management system (hereinafter, referred to as a BMS) 40.

The battery 10 may include a plurality of battery cells connected in series and/or in parallel. In FIG. 2, three battery cells connected in parallel are shown; however, the invention is not limited thereto, and the battery 10 may include various numbers of battery cells connected in series and/or in parallel. In some exemplary embodiments, the battery cells may be rechargeable secondary batteries.

For example, the battery 10 may be a battery pack configured to supply desired power to an external device by forming battery banks each of which is composed of a predetermined number of battery cells connected in parallel and connecting a predetermined number of battery banks in series. For another example, the battery 10 may be a battery pack configured to supply desired power to an external device by forming battery banks each of which is composed of a predetermined number of battery cells connected in parallel and connecting a predetermined number of battery banks in parallel. However, the invention is not limited to these connections, and the battery 10 may include a plurality of battery banks each of which includes a plurality of battery cells connected in series and/or in parallel, the plurality of battery banks may also be connected in series and/or in parallel.

In FIG. 2, the battery 10 is connected between two output terminals OUT1 and OUT2 of the battery system 2. Further, the relay 20 is connected between the positive electrode of the battery system 2 and the first output terminal OUT1, and the current sensor 30 is connected between the negative electrode of the battery system 2 and the second output terminal OUT2. The components and the connection relationship among the components shown in FIG. 2 are an example, and the invention is not limited thereto.

The relay 20 controls the electrical connection between the battery system 2 and an external device. When the relay 20 is turned on, the battery system 2 and the external device are electrically connected such that charging or discharging is performed, and when the relay 20 is turned off, the battery system 2 and the external device are electrically separated. In this case, the external device may be a charger in a charging cycle for supplying power to the battery 10 to charge the battery, and be a load in a discharge cycle in which the battery 10 delivers power to the external device.

The current sensor 30 is connected in series on the current path between the battery 10 and the external device. The current sensor 30 may measure a battery current flowing through the battery 10, i.e., a charging current and a discharge current, and transmit the measurement result to the BMS 40.

The BMS 40 includes a measuring unit 41, a storage unit 43, and a control unit 45. The battery diagnosis apparatus 1 shown in FIG. 1 may correspond to the BMS 40 shown in FIG. 2. Specifically, the functions which are performed by the measuring unit 110, the storage unit 130, and the control unit 150 of the battery diagnosis apparatus 1 may correspond to the functions which are performed by the measuring unit 41, the storage unit 43, and the control unit 45 of the BMS 40, respectively. For example, the battery diagnosis apparatus 1 may be configured separately from the battery system 2. For another example, as shown in FIG. 2, in the battery system 2, the BMS 40 may perform the function of the battery diagnosis apparatus 1.

The measuring unit 41 may be electrically connected between both terminals of the battery 10 so as to be able to measure the battery current and the battery voltage. For example, the measuring unit 41 may be configured with an ASIC (Application Specific Integrated Circuit) for monitoring the battery 10 and measuring battery data (such as voltage and current) corresponding to the state of the battery 10.

For example, the measuring unit 41 may collect battery voltages by sensing the voltage value between both terminals of the battery 10.

The measuring unit 41 may receive the battery current value from the current sensor 30. The measuring unit 41 may transmit the battery voltage value and the battery current value to the control unit 45.

The storage unit 43 may store an internal resistance value which is calculated by the control unit 45 on the basis of at least one of a battery voltage and a battery current at each diagnosis time of diagnosing defects of the battery 10. Also, the control unit 45 may store a battery voltage value and a battery current value received from the measuring unit 41 at each diagnosis time of diagnosing defects of the battery, in the storage unit 43.

According to the exemplary embodiment, the storage unit 43 may store internal resistance values and standard deviations corresponding to a plurality of test diagnosis times determined according to a predetermined criterion, respectively. In this case, test diagnosis times may not be actual diagnosis times of diagnosing defects of a battery 10. Test diagnosis times may be theoretical diagnosis times including experimental values and so on. Specifically, test diagnosis times may be diagnosis times which are complementally provided when the number of actual-measurement diagnosis times is smaller than the number of samples constituting a sample set to be described below. Therefore, test diagnosis times may be stored in the storage unit 130 in association with internal resistance values and standard deviations which are provided to calculate moving averages MA, upper band thresholds UB_Th, and lower band thresholds LB_Th to be described below.

When a diagnosis time (N) according to the predetermined condition comes, the control unit 45 calculates a moving average MA_{N}, an upper band threshold UB_{N}_Th, a lower band threshold LB_{N}_Th, and an internal resistance (DCIR_{N}) value corresponding to the diagnosis time (N). Further, the control unit 45 may diagnose the state of the battery 10 by comparing the internal resistance (DCIR_{N}) value with the upper band threshold UB_{N_}Th and the lower band threshold LB_{N}_Th.

First, the control unit 45 may determine a sample set by extracting a plurality of diagnosis times which is included in the predetermined number of samples SN when counting diagnosis times from the diagnosis time (N) toward the previous diagnosis times. At this time, the number of samples SN may be the number of a plurality of diagnosis times which is included in a sample set, and be set to an optimal number based on experiments and so on. A sample set may be a set of some of a plurality of past diagnosis times constituting a population, and be a set for calculating a moving average MA, a standard deviation averages σ_ave, and so on to be described below.

For example, it is assumed that the number of samples SN is 5. In the above Table 1, the control unit 45 may extract the (N-1)-th diagnosis time, the (N-2)-th diagnosis time, the (N-3)-th diagnosis time, the (N-4)-th diagnosis time, and the (N-5)-th diagnosis time corresponding to 5 which is the number of samples SN when counting diagnosis times from the current diagnosis time (N) toward the previous diagnosis times, to determine a sample set.

According to the exemplary embodiment, when the number of previous diagnosis times of the current diagnosis time (N) is smaller than the number of samples SN, the control unit 45 may add test diagnosis times to the sample set. For example, in the case where the number of previous actual-measurement diagnosis times of the current diagnosis time (N) is three, the control unit 45 may add two predetermined test diagnosis times to the sample set. For another example, in the case where the number of previous actual-measurement diagnosis times of the current diagnosis time (N) is three, the control unit 45 may configure a sample set of only predetermined test diagnosis times. In other words, when the actual-measurement diagnosis times do not correspond to the number of samples, the control unit 45 may configure a sample set of the actual-measurement diagnosis times and test diagnosis times, or configure a sample set of only test diagnosis times.

The control unit 45 may calculate a moving average MA_{N} which is the average of the plurality of internal resistance values corresponding to the plurality of diagnosis times included in the sample set. For example, referring to the above Table 1 and the above Equation 2, the control unit may calculate a moving average (MA_{N}) 22.2 corresponding to the diagnosis time (N) by averaging the plurality of internal resistance values (23 Ω, 24 Ω, 20 Ω, 21 Ω, and 23 Ω) corresponding to the plurality of diagnosis times (N-5, N-4, N-3, N-2, and N-1) included in the sample set, respectively.

For example, referring to the above Table 1 and the above Table 4, the control unit 45 may calculate a standard deviation average σ_{N_ave} (1.70) corresponding to the diagnosis time (N) on the basis of the standard deviations (σ_{N-5}, σ_{N-4}, σ_{N-3}, σ_{N-2}, and σ_{N-1}) corresponding to the plurality of diagnosis times (N-5, N-4, N-3, N-2, and N-1) included in the sample set, respectively.

The control unit 45 determines an upper band threshold UB_{N_}Th and a lower band threshold LB_{N}_Th which are reference values for diagnosing defects of the battery at the current diagnosis time (N), i.e., the N-th diagnosis time, on the basis of the internal resistance values (DCIR_{N}) calculated at the plurality of diagnosis times (N-5, N-4, N-3, N-2, and N-1) included in the sample set, respectively.

The control unit 45 may calculate an upper band threshold UB_{N_}Th larger than the moving average MA_{N} by a predetermined value and a lower band threshold LB_{N}_Th smaller than the moving average MA by a predetermined value. According to the exemplary embodiment, the control unit 45 may calculate a first error value by multiplying the standard deviation average σ_{N_ave} by the predetermined first multiple, and calculate an upper band threshold UB_{N_}Th by adding the first error value to the moving average MA_{N}. Also, the control unit 45 may calculate a second error value by multiplying the standard deviation average σ_{N_ave} by the predetermined second multiple, and calculate a lower band threshold LB_{N}_Th by subtracting the second error value from the moving average MA_{N}. In this case, the first multiple and the second multiple may be the same, but are not limited thereto, and may be set to various multiples.

According to the exemplary embodiment, the control unit 45 may calculate an error value E (= σ_{N_ave} × Q) by multiplying the standard deviation average σ_{N_ave} which is the average of the standard deviations of the sample set and a predetermined multiple Q together. For example, it is assumed that the multiple Q is a natural number 3. The control unit 45 may calculate an upper band threshold (UB_{N}_Th) 27.3 by adding the error value E (= σ_{N_ave} × Q = 1.70 × 3 = 5.1) to the moving average MA_{N} (= 22.2) of the sample set, as shown in the above Equation 3. Also, the control unit 150 may calculate a lower band threshold (LB_{N_}Th) 17.1 by subtracting the error value E (= σ_{N_ave} × Q = 1.70 × 3 = 5.1) from the moving average MA_{N} (= 22.2) of the sample set, as shown in the above Equation 4. In this case, the multiple Q may be a value for reflecting a predetermined error, and may be set to various values by experiments.

Subsequently, the control unit 45 may diagnose defects of the battery 10 by comparing the internal resistance (DCIR_{N}) value corresponding to the N-th diagnosis time with the upper band threshold UB_{N_}Th and the lower band threshold LB_{N}_Th corresponding to the N-th diagnosis time.

According to the exemplary embodiment, when the internal resistance (DCIR_{N}) value exceeds the upper band threshold UB_{N}_Th, the control unit 45 may diagnose that a disconnection defect DD has occurred at at least one of the plurality of battery cells included in the battery 10. When the internal resistance (DCIR_{N}) value is smaller than the lower band threshold LB_{N_}Th, the control unit 45 may diagnose that a short defect SD has occurred at at least one of the plurality of battery cells included in the battery 10. In other words, when the internal resistance (DCIR_{N}) value is out of a normal range from the lower band threshold LB_{N}_Th to the upper band threshold UB_{N}_Th, the control unit 45 may diagnose that a defect (a disconnection defect or a short defect) has occurred in the battery 10. Also, when the internal resistance (DCIR_{N}) value is in the normal range, the control unit 45 may diagnose that the state of the battery 10 is normal.

For example, as described above through Table 1, Table 4, and Equation 1 to Equation 4, 30 (Ω), 27.3, and 17.1 may be calculated as the internal resistance value (DCIR_{N}), the upper band threshold UB_{N}_Th, and the lower band threshold LB_{N}_Th corresponding to the N-th diagnosis time, respectively. In this case, since the internal resistance value (DCIR_{N} = 30) exceeds the upper band threshold (UB_{N_}Th = 27.3), the control unit 45 may diagnose a disconnection defect of the battery 10.

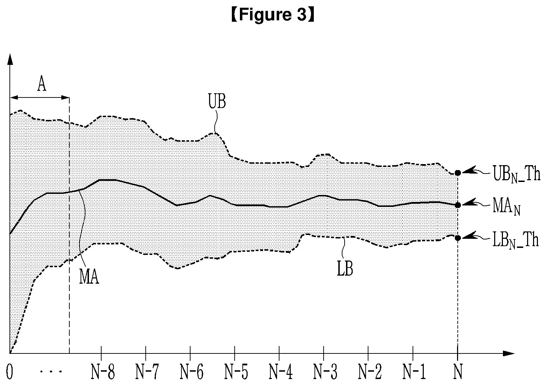

FIG. 3 is a drawing illustrating an example of a cumulative display of moving averages, upper band thresholds, and lower band thresholds calculated at a plurality of diagnosis times, respectively.

Hereinafter, on the basis of FIG. 1 to FIG. 3, Table 1, and Table 4, an example of calculating a moving average MA_{N}, an upper band threshold UB_{N}_Th, and a lower band threshold LB_{N_}Th will be described.

Referring to FIG. 3, the BMS 40 may determine a sample set by extracting a plurality of diagnosis times close to a predetermined diagnosis time (N) while being in environments similar to that of the diagnosis time (N). The BMS 40 may calculate an upper band threshold UB_{N_}Th and a lower band threshold LB_{N}_Th corresponding to the diagnosis time (N), on the basis of the moving average MA_{N} which is the average of the plurality of internal resistance values included in the sample set and the standard deviation average σ_{N_ave} which is the average of the plurality of standard deviations.

According to the exemplary embodiment, first, the BMS 40 may extract the (N-1)-th diagnosis time, the (N-2)-th diagnosis time, the (N-3)-th diagnosis time, the (N-4)-th diagnosis time, and the (N-5)-th diagnosis time corresponding to 5 which is the number of samples SN when counting diagnosis times from a predetermined current diagnosis time (N) toward the previous diagnosis times.

Subsequently, the BMS 40 may average the plurality of internal resistance values (23 Ω, 24 Ω, 20 Ω, 21 Ω, and 23 Ω) corresponding to the plurality of extracted diagnosis times (N-5, N-4, N-3, N-2, and N-1), respectively, thereby calculating a moving average 22.2 Ω (= (23 Ω + 24 Ω + 20 Ω + 21 Ω + 23 Ω) / 5 ) corresponding to the diagnosis time (N).

Through Table 4, Equation 3, and Equation 4 described above, the BMS 40 may calculate an upper band threshold (27.3) and a lower band threshold (17.1).

Subsequently, the BMS 40 may diagnose defects of the battery 10 by comparing the internal resistance (DCIR_{N}) value with the upper band threshold UB_{N_}Th and the lower band threshold LB_{N}_Th. In this case, for example, it is assumed that the internal resistance (DCIR_{N}) is 30 Ω. Since the internal resistance value (DCIR_{N} = 30) exceeds the upper band threshold (UB_{N}_Th = 27.3), the BMS 40 may diagnose a disconnection defect of the battery.

An internal resistance band (DCIR Band) shown in FIG. 3 may be derived by connecting moving averages MA, upper band thresholds UB_Th, and lower band thresholds LB_Th calculated at the plurality of diagnosis times, respectively. The internal resistance band (DCIR Band) may show a transition of the internal resistance value which changes as the battery 10 is used.

In FIG. 3, at a diagnosis time corresponding to section A, there may not be any previous diagnosis times or there may be a lack of previous diagnosis times corresponding to the number of samples. As described above, in this case, test diagnosis times may be supplemented as many as the number of actual-measurement diagnosis times lacking in the number of samples SN.

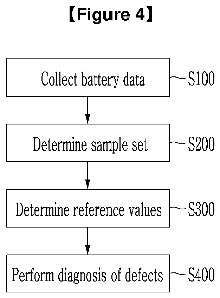

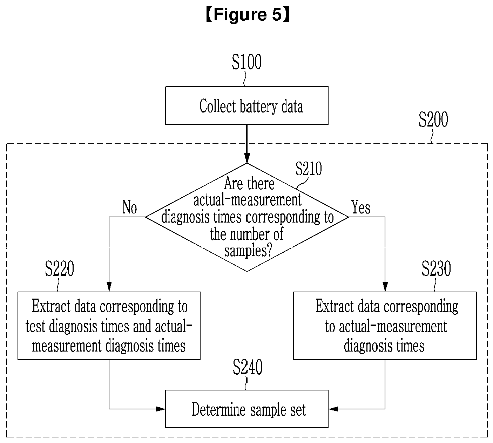

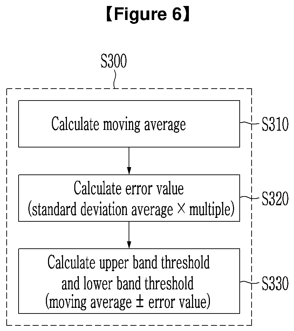

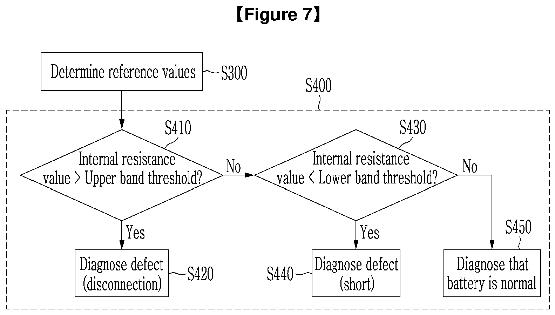

FIG. 4 is a flow chart for explaining a battery diagnosis method according to an exemplary embodiment, and FIG. 5 is a flow chart for explaining the sample-set determining step S200 of FIG. 4 in detail, and FIG. 6 is a flow chart for explaining the reference-value determining step S300 of FIG. 4 in detail, and FIG. 7 is a flow chart for explaining the defect diagnosis step S400 of FIG. 4 in detail.

Hereinafter, referring to FIG. 1 to FIG. 7, a battery diagnosis method, and a battery diagnosis apparatus and a battery system for providing the method will be described. The battery diagnosis method which is performed in the battery system 2 to be described below may be equally applied to the battery diagnosis apparatus 1.

First, the BMS 40 collects battery data (S100). In this case, the battery data may include a battery voltage which is the voltage between both terminals of the battery 10, and a battery current which is a current flowing through the battery 10.

For example, the battery voltage and the battery current may be battery data necessary to calculate the internal resistance (DCIR; Direct Current Internal Resistance) of the battery.

Subsequently, the BMS 40 extracts a plurality of diagnosis times close to a predetermined diagnosis time (N), to determine a sample set (S200).

The BMS 40 may extract a plurality of diagnosis times corresponding to the predetermined number of samples SN when counting diagnosis times from the predetermined diagnosis time (N), i.e., the N-th diagnosis time toward the previous diagnosis times, to determine a sample set.

In STEP S200, referring to FIG. 5, the BMS 40 determines whether there are actual-measurement diagnosis times corresponding to the number of samples SN (S210).

If the determination result in S210 is yes, the BMS 40 extracts data items corresponding to the actual-measurement diagnosis times corresponding to the number of samples, and determines a sample set (S220 and S240).

For example, it is assumed that the number of samples SN is 5. In the above Table 1, the BMS 40 may extract the (N-1)-th diagnosis time, the (N-2)-th diagnosis time, the (N-3)-th diagnosis time, the (N-4)-th diagnosis time, and the (N-5)-th diagnosis time corresponding to 5 which is the predetermined number of samples SN when counting diagnosis times from the N-th diagnosis time toward the previous diagnosis times, and determine a sample set.

If the determination result in S210 is no, the BMS 40 may extract data items corresponding to the test diagnosis times and the actual-measurement diagnosis times from the storage unit 43, and determine a sample set (S230 and S240).

For example, it is assumed that the number of samples SN is 5. In the case where there are not diagnosis times corresponding to 5 which is the number of samples SN when the BMS 40 counts diagnosis times from the N-th diagnosis time toward the previous diagnosis times, in the above Table 1, the BMS 40 may extract test diagnosis times of Table 2, and determine a sample set.

For example, referring to Table 1 and Table 2, at the first diagnosis time (1), there is no previous actual-measurement diagnosis times corresponding to the number of samples SN. The control unit 150 may extract the minus fifth to minus first diagnosis times (-5, -4, -3, -2, and -1) which are test diagnosis times, and determine a sample set.

For another example, referring to Table 1 and Table 2, at the third diagnosis time (3), there is a lack of previous actual-measurement diagnosis times corresponding to the number of samples SN. The control unit 150 may extract the minus third to minus first diagnosis times (-3, -2, and -1) which are test diagnosis times, and the first and second diagnosis times (1 and 2) which are actual-measurement diagnosis times, and determine a sample set.

Subsequently, the BMS 40 determines reference values for diagnosing defects of the battery 10 (S300). According to the exemplary embodiment, the reference values may include an upper band threshold UB_{N_}TH and a lower band threshold LB_{N_}TH.

In STEP S300, referring to FIG. 6, the BMS 40 calculates the moving average MA_{N} of the sample set by averaging the internal resistance values corresponding to the plurality of diagnosis times belonging to the sample set, respectively (S310).

Referring to the above Table 1 and the above Equation 2, the BMS 40 may calculate a moving average (MA_{N}) 22.2 corresponding to the diagnosis time (N) by averaging the plurality of internal resistance values (23 Ω, 24 Ω, 20 Ω, 21 Ω, and 23 Ω) corresponding to the plurality of diagnosis times (N-5, N-4, N-3, N-2, and N-1) included in the sample set, respectively.

In STEP S300, the BMS 40 calculates an error value E on the basis of the standard deviation average σ_{N_ave} of the sample set (S320).

For example, the standard deviation average σ_{N_ave} of the sample set may be calculated by averaging a plurality of standard deviations (σ_{N-5}, σ_{N-4}, σ_{N-3}, σ_{N-2}, and σ_{N-1}) corresponding to the plurality of diagnosis times (N-5, N-4, N-3, N-2, and N-1) belonging to the sample set, respectively.

Referring to the above Table 1 and the above Table 3, the BMS 40 may calculate a standard deviation average σ_{N_ave} (1.70) corresponding to the N-th diagnosis time (N), on the basis of the plurality of standard deviations (σₙ₋₅, σ_{N-4}, σ_{N-3}, σ_{N-2}, and σ_{N-1}) corresponding to the plurality of diagnosis times (N-5, N-4, N-3, N-2, and N-1) belonging to the sample set, respectively. Also, the BMS 40 may calculate an error value E (= σ_{N_ave} × Q = 1.70 × 3 = 5.1) by multiplying the standard deviation average σ_{N_ave} and the predetermined multiple Q together. In this case, the multiple Q may be a value for reflecting a predetermined error, and may be set to various values by experiments. For example, it is assumed that the multiple Q is a natural number 3.

In STEP S300, the BMS 40 calculates an upper band threshold UB_{N_}Th and a lower band threshold LB_{N}_Th on the basis of the moving average MA_{N} and the error value E (S330).

Referring to the above Equation 3, the BMS 40 may calculate an upper band threshold (UB_{N}_Th) 27.3 by adding the error value E (= σ_{N_ave} × Q = 1.70 × 3 = 5.1) to the moving average MA_{N} (= 22.2) of the sample set. Also, referring to the above Equation 4, the BMS 40 may calculate a lower band threshold (LB_{N_}Th) 17.1 by subtracting the error value E (= σ_{N_ave} × Q = 1.70 × 3 = 5.1) from the moving average MA_{N} (= 22.2) of the sample set.

Subsequently, the BMS 40 diagnoses defects of the battery 10 by comparing the internal resistance (DCIR_{N}) value corresponding to the diagnosis time (N) with the upper band threshold UB_{N_}Th and the lower band threshold LB_{N}_Th corresponding to the diagnosis time (N) (S400).

The BMS 40 may calculate an internal resistance (DCIR_{N}) value corresponding to the N-th diagnosis time, on the basis of a battery voltage which is the voltage between both terminals of a battery and a battery current which is a current flowing through the battery. Also, the internal resistance (DCIR_{N}) value may be calculated in STEP S200 or STEP S300; however, the calculation time thereof is not limited as long as it is calculated before STEP S400 which is the diagnosis time.

For example, the BMS 40 may calculate the voltage difference between a battery voltage V1 corresponding to a first time when charging starts and a battery voltage V2 corresponding to a second time that is a predetermined time later from the first time (ΔV = | V1 - V2|). The BMS 40 may calculate an internal resistance (DCIR_{N}) value on the basis of a charging current I flowing through the battery 10 and the voltage difference ΔV. For example, it is assumed that 30 Ω is calculated as the internal resistance (DCIR_{N}) value corresponding to the N-th diagnosis time.

In STEP S400, referring to FIG. 7, the BMS 40 determines whether the internal resistance (DCIR_{N}) value exceeds the upper band threshold UB_{N_}Th (S410).

In STEP S400, when the determination result in STEP S410 is yes, the BMS 40 diagnoses that a disconnection defect has occurred at at least one of the plurality of battery cells included in the battery 10 (S420).

For example, when the parallel connection between some battery cells of the plurality of battery cells connected in parallel is broken, the internal resistance value of the battery 10 may increase.

In STEP S400, when the determination result in STEP S410 is no, the BMS 40 determines whether the internal resistance value (DCIR_{N}) is smaller than the lower band threshold LB_{N}_Th (S430).

In STEP S400, when the determination result in STEP S430 is yes, the BMS 40 diagnoses that a short defect has occurred at at least one of the plurality of battery cells included in the battery 10 (S440).

For example, when some battery cells of the plurality of battery cells connected in parallel are short-circuited, the internal resistance value which is the total resistance of the battery 10 may decrease.

In STEP S400, when the determination result in STEP S430 is no, the BMS 40 diagnoses that the state of the battery 10 is normal (S450).

Also, when the internal resistance (DCIR_{N}) value is out of the normal range from the lower band threshold LB_{N}_Th to the upper band threshold UB_{N}_Th, the BMS 40 may diagnose a defect (a disconnection defect or a short defect) as the state of the battery 10. Further, when the internal resistance (DCIR_{N}) value is in the normal range, the BMS 40 may diagnose that the state of the battery 10 is normal.

While this invention has been described in connection with what is presently considered to be practical exemplary embodiments, it is to be understood that the invention is not limited to the disclosed embodiments. On the contrary, it is intended to cover various modifications included within the scope of the appended claims.

## Claims

1. A battery diagnosis apparatus (1) comprising:
a measuring unit (110) configured to measure a battery voltage, which is a voltage between both terminals of a battery and a battery current which is a current flowing through the battery;
a storage unit (130) configured to store a plurality of actual-measurement internal resistance values, each of which has been calculated based on at least one of the battery voltage and the battery current at each diagnosis time when diagnosing defects of the battery, and at least one test internal resistance value determined according to a predetermined criterion; wherein the battery diagnosis apparatus is **characterised by**:
a control unit (150) configured to extract a plurality of previous diagnosis times, corresponding to a predetermined number of samples, from each diagnosis time, at the diagnosis time, calculate a moving average, which is the average of a plurality of actual-measurement internal resistance values corresponding to the plurality of diagnosis times, respectively, and diagnose defects of the battery by comparing an actual-measurement internal resistance value calculated at each diagnosis time with reference values calculated based on the moving average,
wherein when the number of the extracted plurality of previous diagnosis times is less than the predetermined number of samples, the control unit calculates the moving average based on the plurality of actual-measurement internal resistance values and the test internal resistance values corresponding to the predetermined number of samples.

2. The battery diagnosis apparatus (1) of claim 1, wherein
the reference values include an upper band threshold larger than the moving average by a predetermined value, and a lower band threshold smaller than the moving average by a predetermined value.

3. The battery diagnosis apparatus (1) of claim 2, wherein
the control unit (150) is configured to:
calculate an error value by multiplying a standard deviation average which is the average of a plurality of actual-measurement standard deviations corresponding to the plurality of diagnosis times, respectively, by a predetermined multiple;
calculate the upper band threshold by adding the error value to the moving average; and
calculate the lower band threshold by subtracting the error value from the moving average.

4. The battery diagnosis apparatus (1) of claim 3, wherein
the storage unit (130) is further configured to store the actual-measurement standard deviations calculated at the individual diagnosis times, and at least one test standard deviation determined according to a predetermined criterion, and
when the number of the extracted plurality of previous diagnosis times is less than the predetermined number of samples, the control unit calculates the standard deviation average based on the actual-measurement standard deviations and the test standard deviations corresponding to the predetermined number of samples.

5. The battery diagnosis apparatus (1) of claim 2, wherein
when the actual-measurement internal resistance value calculated at each diagnosis time exceeds the upper band threshold, the control unit diagnoses that a disconnection defect has occurred at at least one of a plurality of battery cells included in the battery.

6. The battery diagnosis apparatus (1) of claim 2, wherein
when the actual-measurement internal resistance value calculated at each diagnosis time is smaller than the lower band threshold, the control unit diagnoses that a short defect has occurred at at least one of a plurality of battery cells included in the battery.

7. A battery system (2) comprising:
a battery (10) that includes a plurality of battery cells; and a battery diagnosis apparatus according to any one of claims 1-6.

8. The battery system (2) of claim 7, wherein
the reference values include an upper band threshold larger than the moving average by a predetermined value, and a lower band threshold smaller than the moving average by a predetermined value.

9. The battery system (2) of claim 8, wherein
the control unit (45) is configured to:
calculate an error value by multiplying a standard deviation average which is the average of a plurality of actual-measurement standard deviations corresponding to the plurality of diagnosis times, respectively, by a predetermined multiple;
calculate the upper band threshold by adding the error value to the moving average; and
calculate the lower band threshold by subtracting the error value from the moving average.

10. The battery system (2) of claim 9, wherein
the storage unit (43) is further configured to store the actual-measurement standard deviations calculated at the individual diagnosis times, and at least one test standard deviation determined according to a predetermined criterion, and
when the number of the extracted plurality of previous diagnosis times is less than the predetermined number of samples, the control unit calculates the standard deviation average based on the actual-measurement standard deviations and the test standard deviations corresponding to the predetermined number of samples.

11. The battery system (2) of claim 8, wherein
when the actual-measurement internal resistance value calculated at each diagnosis time exceeds the upper band threshold, the control unit diagnoses that a disconnection defect has occurred at at least one of the plurality of battery cells.

12. The battery system (2) of claim 10, wherein
when the actual-measurement internal resistance value calculated at each diagnosis time is smaller than the lower band threshold, the control unit diagnoses that a short defect has occurred at at least one of the plurality of battery cells.

13. A battery diagnosis method comprising steps of:
collecting (S100) measurement values of each of battery voltage, which is a voltage between both terminals of a battery and a battery current which is the current flowing through the battery;
determining (S200) a sample set by extracting a plurality of previous diagnosis times corresponding to a predetermined number of samples from a predetermined diagnosis time when diagnosing defects of the battery; wherein the battery diagnosis method is **characterised by**:
calculating (S310) a moving average, which is the average of a plurality of actual-measurement internal resistance values corresponding to the plurality of diagnosis times belonging to the sample set, respectively, and calculating (S300) reference values, which are references for diagnosing defects of the battery, based on the moving average; and
diagnosing defects (S400) of the battery by comparing an actual-measurement internal resistance value corresponding to the predetermined diagnosis time with the reference values,
wherein when the number of the extracted plurality of previous diagnosis times is less than the predetermined number of samples, the moving average is calculated based on the plurality of actual-measurement internal resistance values and test internal resistance values corresponding to the predetermined number of samples, and
at each diagnosis time, the actual-measurement internal resistance value is calculated based on at least one of the battery voltage and the battery current, and the test internal resistance values are determined according to a predetermined criterion.

14. The battery diagnosis method of claim 13, wherein
the reference values include an upper band threshold larger than the moving average by a predetermined value, and a lower band threshold smaller than the moving average by a predetermined value.

15. The battery diagnosis method of claim 14, wherein
the calculating the reference values (S300) further includes:
calculating (S320) an error value by multiplying a standard deviation average which is the average of a plurality of actual-measurement standard deviations corresponding to the plurality of diagnosis times, respectively, by a predetermined multiple, and
calculating (S330) the upper band threshold by adding the error value to the moving average, and
calculating (S330) the lower band threshold by subtracting the error value from the moving average.

16. The battery diagnosis method of claim 15, wherein
the calculating the reference values (S300) further includes calculating the standard deviation average based on actual-measurement standard deviations and test standard deviations corresponding to the predetermined number of samples, when the number of the extracted plurality of previous diagnosis times is less than the predetermined number of samples, and
at each diagnosis time, the actual-measurement standard deviation is calculated based on the plurality of actual-measurement internal resistance values corresponding to the predetermined number of samples, and
the test standard deviations are determined according to a predetermined criterion.

17. The battery diagnosis method of claim 15, wherein
the calculating the reference values (S300) further includes calculating the moving average based on the test internal resistance values corresponding to the predetermined number of samples when the plurality of previous diagnosis times does not exist.

18. The battery diagnosis method of claim 14, wherein
the diagnosing defects of the battery includes diagnosing that a disconnection defect has occurred at at least one of a plurality of battery cells included in the battery, when the actual-measurement internal resistance value calculated at each diagnosis time exceeds the upper band threshold.

19. The battery diagnosis method of claim 14, wherein
the diagnosing defects (S400) of the battery includes diagnosing (S440) that a short defect has occurred at at least one of a plurality of battery cells included in the battery, when the actual-measurement internal resistance value calculated at each diagnosis time is smaller than the lower band threshold.

## Patentansprüche

1. Batteriediagnoseeinrichtung (1), umfassend:
eine Messeinheit (110), die konfiguriert ist, um eine Batteriespannung, die eine Spannung zwischen beiden Anschlüssen einer Batterie ist, und einen Batteriestrom, der ein durch die Batterie fließender Strom ist, zu messen;
eine Speichereinheit (130), die konfiguriert ist, um eine Vielzahl von Innenwiderstandswerten einer tatsächlichen Messung zu speichern, von denen jeder basierend auf mindestens einem von der Batteriespannung und dem Batteriestrom zu jedem Diagnosezeitpunkt beim Diagnostizieren von Fehlern der Batterie berechnet wurde, und mindestens einen Test-Innenwiderstandswert, der gemäß einem vorbestimmten Kriterium bestimmt wurde;
wobei die Batteriediagnoseeinrichtung **gekennzeichnet ist durch**:
eine Steuereinheit (150), die konfiguriert ist, um eine Vielzahl von vorherigen Diagnosezeitpunkten, die einer vorbestimmten Anzahl an Proben entsprechen, aus jedem Diagnosezeitpunkt zu extrahieren, zum Diagnosezeitpunkt einen gleitenden Mittelwert zu berechnen, der der Mittelwert einer Vielzahl von Innenwiderstandswerten einer tatsächlichen Messung ist, die jeweils der Vielzahl von Diagnosezeitpunkten entsprechen, und Fehler der Batterie **durch** Vergleichen einer Innenwiderstandswert einer tatsächlichen Messung, der zu jedem Diagnosezeitpunkt berechnet wird, mit Referenzwerten zu diagnostizieren, die basierend auf dem gleitenden Mittelwert berechnet werden,
wobei, wenn die Anzahl der extrahierten Vielzahl von vorherigen Diagnosezeitpunkten geringer ist als die vorbestimmte Anzahl an Proben, die Steuereinheit den gleitenden Mittelwert basierend auf der Vielzahl von Innenwiderstandswerten einer tatsächlichen Messung und der Test-Innenwiderstandswerte berechnet, die der vorbestimmten Anzahl an Proben entsprechen.

2. Batteriediagnoseeinrichtung (1) nach Anspruch 1, wobei
die Referenzwerte einen oberen Bandgrenzwert, der um einen vorbestimmten Wert größer ist als der gleitende Mittelwert, und einen unteren Bandgrenzwert, der um einen vorbestimmten Wert kleiner ist als der gleitende Mittelwert, beinhalten.

3. Batteriediagnoseeinrichtung (1) nach Anspruch 2, wobei
die Steuereinheit (150) konfiguriert ist, um:
einen Fehlerwertdurch Multiplizieren eines Standardabweichungsmittelwert, der der Mittelwert einer Vielzahl von Standardabweichungen einer tatsächlichen Messung ist, die jeweils der Vielzahl von Diagnosezeitpunkten entsprechen, mit einem vorbestimmten Vielfachen zu berechnen;
und
den oberen Bandgrenzwert durch Addieren des Fehlerwerts zu dem gleitenden Mittelwert zu berechnen;
den unteren Bandgrenzwert durch Subtrahieren des Fehlerwerts von dem gleitenden Mittelwert zu berechnen.

4. Batteriediagnoseeinrichtung (1) nach Anspruch 3, wobei
die Speichereinheit (130) weiter konfiguriert ist, um die Standardabweichungen einer tatsächlichen Messung, die zu den einzelnen Diagnosezeitpunkten berechnet werden, und mindestens eine Test-Standardabweichung, die gemäß einem vorbestimmten Kriterium bestimmt wird, zu speichern, und
wenn die Anzahl der extrahierten Vielzahl von vorherigen Diagnosezeitpunkten geringer ist als die vorbestimmte Anzahl an Proben, die Steuereinheit den Standardabweichungsmittelwert basierend auf den Standardabweichungen einer tatsächlichen Messung und den Test-Standardabweichungen berechnet, die der vorbestimmten Anzahl an Proben entsprechen.

5. Batteriediagnoseeinrichtung (1) nach Anspruch 2, wobei
wenn der Innenwiderstandswert einer tatsächlichen Messung, der zu jedem Diagnosezeitpunkt berechnet wird, den oberen Bandgrenzwert überschreitet, die Steuereinheit diagnostiziert, dass ein Unterbrechungsfehler bei mindestens einer von einer Vielzahl von in der Batterie beinhalteten Batteriezellen aufgetreten ist.

6. Batteriediagnoseeinrichtung (1) nach Anspruch 2, wobei
wenn der Innenwiderstandswert einer tatsächlichen Messung, der zu jedem Diagnosezeitpunkt berechnet wird, kleiner ist als der untere Bandgrenzwert, die Steuereinheit diagnostiziert, dass ein Kurzschlussfehler bei mindestens einer von einer Vielzahl von in der Batterie beinhalteten Batteriezellen aufgetreten ist.

7. Batteriesystem (2), umfassend:
eine Batterie (10), die eine Vielzahl von Batteriezellen beinhaltet;
und eine Batteriediagnoseeinrichtung nach einem der Ansprüche 1-6.

8. Batteriesystem (2) nach Anspruch 7, wobei
die Referenzwerte einen oberen Bandgrenzwert, der um einen vorbestimmten Wert größer ist als der gleitende Mittelwert, und einen unteren Bandgrenzwert, der um einen vorbestimmten Wert kleiner ist als der gleitende Mittelwert, beinhalten.

9. Batteriesystem (2) nach Anspruch 8, wobei
die Steuereinheit (45) konfiguriert ist, um:
einen Fehlerwert durch Multiplizieren eines Standardabweichungsmittelwerts, der der Mittelwert einer Vielzahl von Standardabweichungen einer tatsächlichen Messung ist, die der Vielzahl von Diagnosezeitpunkten entsprechen, jeweils mit einem vorbestimmten Vielfachen zu berechnen;
den oberen Bandgrenzwert durch Addieren des Fehlerwerts zu dem gleitenden Mittelwert zu berechnen;
und
den unteren Bandgrenzwert durch Subtrahieren des Fehlerwerts von dem gleitenden Mittelwert zu berechnen.

10. Batteriesystem (2) nach Anspruch 9, wobei
die Speichereinheit (43) weiter konfiguriert ist, um die Standardabweichungen einer tatsächlichen Messung, die zu den einzelnen Diagnosezeitpunkten berechnet werden, und mindestens eine Test-Standardabweichung, die gemäß einem vorbestimmten Kriterium bestimmt wird, zu speichern, und
wenn die Anzahl der extrahierten Vielzahl von vorherigen Diagnosezeitpunkten geringer ist als die vorbestimmte Anzahl an Proben, die Steuereinheit den Standardabweichungsmittelwert basierend auf den Standardabweichungen einer tatsächlichen Messung und den Test-Standardabweichungen berechnet, die der vorbestimmten Anzahl an Proben entsprechen.

11. Batteriesystem (2) nach Anspruch 8, wobei
wenn der Innenwiderstandswert einer tatsächlichen Messung, der zu jedem Diagnosezeitpunkt berechnet wird, den oberen Bandgrenzwert überschreitet, die Steuereinheit diagnostiziert, dass ein Unterbrechungsfehler bei mindestens einer der Vielzahl von Batteriezellen aufgetreten ist.

12. Batteriesystem (2) nach Anspruch 10, wobei
wenn der Innenwiderstandswert einer tatsächlichen Messung, der zu jedem Diagnosezeitpunkt berechnet wird, kleiner ist als der untere Bandgrenzwert, die Steuereinheit diagnostiziert, dass ein Kurzschlussfehler bei mindestens einer der Vielzahl von Batteriezellen aufgetreten ist.

13. Batteriediagnoseverfahren, umfassend die Schritte zum:
Erheben (S100) von Messwerten jeder Batteriespannung, die eine Spannung zwischen beiden Anschlüssen einer Batterie ist, und eines Batteriestroms, der der durch die Batterie fließende Strom ist;
Bestimmen (S200) einer Probensatzes durch Extrahieren einer Vielzahl von vorherigen Diagnosezeitpunkten, die einer vorbestimmten Anzahl an Proben aus einem vorbestimmten Diagnosezeitpunkt entsprechen, wenn Fehler der Batterie diagnostiziert werden;
wobei das Batteriediagnoseverfahren **gekennzeichnet ist durch**:
Berechnen (S310) eines gleitenden Mittelwerts, der der Mittelwert einer Vielzahl von Innenwiderstandswerten einer tatsächlichen Messung ist, die der Vielzahl von Diagnosezeitpunkten entsprechen, die dem Probensatz angehören, und Berechnen (S300) von Referenzwerten, die Referenzen für die Diagnose von Fehlern der Batterie sind, basierend auf dem gleitenden Mittelwert; und
Diagnostizieren von Fehlern (S400) der Batterie **durch** Vergleichen eines Innenwiderstandswerts einer tatsächlichen Messung, der dem vorbestimmten Diagnosezeitpunkt entspricht, mit den Referenzwerten,
wobei, wenn die Anzahl der extrahierten Vielzahl von vorherigen Diagnosezeitpunkten geringer ist als die vorbestimmte Anzahl an Proben, der gleitende Mittelwert basierend auf der Vielzahl von Innenwiderstandswerten einer tatsächlichen Messung und Test-Innenwiderstandswerten berechnet wird, die der vorbestimmten Anzahl an Proben entsprechen, und
zu jedem Diagnosezeitpunkt der Innenwiderstandswert einer tatsächlichen Messung basierend auf mindestens einem von der Batteriespannung und dem Batteriestrom berechnet wird, und die Test-Innenwiderstandswerte gemäß einem vorbestimmten Kriterium bestimmt werden.

14. Batteriediagnoseverfahren nach Anspruch 13, wobei
die Referenzwerte einen oberen Bandgrenzwert, der um einen vorbestimmten Wert größer ist als der gleitende Mittelwert, und einen unteren Bandgrenzwert, der um einen vorbestimmten Wert kleiner ist als der gleitende Mittelwert, beinhalten.

15. Batteriediagnoseverfahren nach Anspruch 14, wobei
das Berechnen der Referenzwerte (S300) weiter beinhaltet:
Berechnen (S320) eines Fehlerwerts durch Multiplizieren eines Standardabweichungsmittelwerts, der der Mittelwert einer Vielzahl von Standardabweichungen einer tatsächlichen Messi,g ist, die der Vielzahl von Diagnosezeitpunkten entsprechen, jeweils mit einem vorbestimmten Vielfachen, und
Berechnen (S330) des oberen Bandgrenzwerts durch Addieren des Fehlerwerts zum gleitenden Mittelwert, und
Berechnen (S330) des unteren Bandgrenzwerts durch Subtrahieren des Fehlerwerts vom gleitenden Mittelwert.

16. Batteriediagnoseverfahren nach Anspruch 15, wobei
das Berechnen der Referenzwerte (S300) weiter Berechnen des Standardabweichungsmittelwerts basierend auf Standardabweichungen einer tatsächlichen Messung und Test-Standardabweichungen beinhaltet, die der vorbestimmten Anzahl an Proben entsprechen, wenn die Anzahl der extrahierten Vielzahl von vorherigen Diagnosezeitpunkten geringer ist als die vorbestimmte Anzahl an Proben, und
zu jedem Diagnosezeitpunkt die Standardabweichung einer tatsächlichen Messung basierend auf der Vielzahl von Innenwiderstandswerten einer tatsächlichen Messung berechnet wird, die der vorbestimmten Anzahl an Proben entsprechen, und
die Test-Standardabweichungen gemäß einem vorbestimmten Kriterium bestimmt werden.

17. Batteriediagnoseverfahren nach Anspruch 15, wobei
das Berechnen der Referenzwerte (S300) weiter Berechnen des gleitenden Mittelwerts basierend auf den Test-Innenwiderstandswerten beinhaltet, die der vorbestimmten Anzahl an Proben entsprechen, wenn die Vielzahl von vorherigen Diagnosezeitpunkten nicht existiert.

18. Batteriediagnoseverfahren nach Anspruch 14, wobei
das Diagnostizieren von Fehlern der Batterie Diagnostizieren beinhaltet, dass ein Unterbrechungsfehler bei mindestens einer von einer Vielzahl von in der Batterie beinhalteten Batteriezellen aufgetreten ist, wenn der Innenwiderstandswert einer tatsächlichen Messung, der zu jedem Diagnosezeitpunkt berechnet wird, den oberen Bandgrenzwert überschreitet.

19. Batteriediagnoseverfahren nach Anspruch 14, wobei
das Diagnostizieren von Fehlern (S400) der Batterie Diagnostizieren (S440) beinhaltet, dass ein Kurzschlussfehler bei mindestens einer von einer Vielzahl von in der Batterie beinhalteten Batteriezellen aufgetreten ist, wenn der Innenwiderstandswert einer tatsächlichen Messung, der zu jedem Diagnosezeitpunkt berechnet wird, kleiner ist als der untere Bandgrenzwert.

## Revendications

1. Appareil de diagnostic de batterie (1) comprenant :
une unité de mesure (110) configurée pour mesurer une tension de batterie, qui est une tension entre les deux bornes d'une batterie, et un courant de batterie, qui est un courant circulant à travers la batterie ;
une unité de stockage (130) configurée pour stocker une pluralité de valeurs de résistance interne de mesure réelle, dont chacune a été calculée sur la base d'au moins l'une de la tension de batterie et du courant de batterie à chaque temps de diagnostic lors du diagnostic de défauts de la batterie, et au moins une valeur de résistance interne de test déterminée selon un critère prédéterminé ;
l'appareil de diagnostic de batterie étant **caractérisé par** :
une unité de commande (150) configurée pour extraire une pluralité de temps de diagnostic précédents, correspondant à un nombre prédéterminé d'échantillons, de chaque temps de diagnostic, au temps de diagnostic, calculer une moyenne mobile, qui est la moyenne d'une pluralité de valeurs de résistance interne de mesure réelle correspondant à la pluralité de temps de diagnostic, respectivement, et diagnostiquer des défauts de la batterie en comparant une valeur de résistance interne de mesure réelle calculée à chaque temps de diagnostic avec des valeurs de référence calculées sur la base de la moyenne mobile,
dans lequel, lorsque le nombre de la pluralité extraite de temps de diagnostic précédents est inférieur au nombre prédéterminé d'échantillons, l'unité de commande calcule la moyenne mobile sur la base de la pluralité de valeurs de résistance interne de mesure réelle et des valeurs de résistance interne de test correspondant au nombre prédéterminé d'échantillons.

2. Appareil de diagnostic de batterie (1) selon la revendication 1, dans lequel
les valeurs de référence incluent un seuil de bande supérieure plus grand que la moyenne mobile d'une valeur prédéterminée, et un seuil de bande inférieure plus petit que la moyenne mobile d'une valeur prédéterminée.

3. Appareil de diagnostic de batterie (1) selon la revendication 2, dans lequel
l'unité de commande (150) est configurée pour :
calculer une valeur d'erreur en multipliant une moyenne d'écart-type qui est la moyenne d'une pluralité d'écarts-types de mesure réelle correspondant à la pluralité de temps de diagnostic, respectivement, par un multiple prédéterminé ;
et
calculer le seuil de bande supérieure en ajoutant la valeur d'erreur à la moyenne mobile ; ;
calculer le seuil de bande inférieure en soustrayant la valeur d'erreur de la moyenne mobile.

4. Appareil de diagnostic de batterie (1) selon la revendication 3, dans lequel
l'unité de stockage (130) est en outre configurée pour stocker les écarts-types de mesure réelle calculés aux temps de diagnostic individuels, et au moins un écart-type de test déterminé selon un critère prédéterminé, et
lorsque le nombre de la pluralité extraite de temps de diagnostic précédents est inférieur au nombre prédéterminé d'échantillons, l'unité de commande calcule la moyenne d'écart-type sur la base des écarts-types de mesure réelle et des écarts-types de test correspondant au nombre prédéterminé d'échantillons.

5. Appareil de diagnostic de batterie (1) selon la revendication 2, dans lequel
lorsque la valeur de résistance interne de mesure réelle calculée à chaque temps de diagnostic dépasse le seuil de bande supérieure, l'unité de commande diagnostique qu'un défaut de déconnexion s'est produit au niveau d'au moins l'une d'une pluralité de cellules de batterie incluses dans la batterie.

6. Appareil de diagnostic de batterie (1) selon la revendication 2, dans lequel
lorsque la valeur de résistance interne de mesure réelle calculée à chaque temps de diagnostic est inférieure au seuil de bande inférieure, l'unité de commande diagnostique qu'un défaut de court-circuit s'est produit au niveau d'au moins l'une d'une pluralité de cellules de batterie incluses dans la batterie.

7. Système de batterie (2) comprenant :
une batterie (10) qui inclut une pluralité de cellules de batterie ; et un appareil de diagnostic de batterie selon l'une quelconque des revendications 1 à 6.

8. Système de batterie (2) selon la revendication 7, dans lequel
les valeurs de référence incluent un seuil de bande supérieure plus grand que la moyenne mobile d'une valeur prédéterminée, et un seuil de bande inférieure plus petit que la moyenne mobile d'une valeur prédéterminée.

9. Système de batterie (2) selon la revendication 8, dans lequel
l'unité de commande (45) est configurée pour :
calculer une valeur d'erreur en multipliant une moyenne d'écart-type qui est la moyenne d'une pluralité d'écarts-types de mesure réelle correspondant à la pluralité de temps de diagnostic, respectivement, par un multiple prédéterminé ;
calculer le seuil de bande supérieure en ajoutant la valeur d'erreur à la moyenne mobile ; ;
et
calculer le seuil de bande inférieure en soustrayant la valeur d'erreur de la moyenne mobile.

10. Système de batterie (2) selon la revendication 9, dans lequel
l'unité de stockage (43) est en outre configurée pour stocker les écarts-types de mesure réelle calculés aux temps de diagnostic individuels, et au moins un écart-type de test déterminé selon un critère prédéterminé, et
lorsque le nombre de la pluralité extraite de temps de diagnostic précédents est inférieur au nombre prédéterminé d'échantillons, l'unité de commande calcule la moyenne d'écart-type sur la base des écarts-types de mesure réelle et des écarts-types de test correspondant au nombre prédéterminé d'échantillons.

11. Système de batterie (2) selon la revendication 8, dans lequel
lorsque la valeur de résistance interne de mesure réelle calculée à chaque temps de diagnostic dépasse le seuil de bande supérieure, l'unité de commande diagnostique qu'un défaut de déconnexion s'est produit au niveau d'au moins l'une de la pluralité de cellules de batterie.

12. Système de batterie (2) selon la revendication 10, dans lequel
lorsque la valeur de résistance interne de mesure réelle calculée à chaque temps de diagnostic est inférieure au seuil de bande inférieure, l'unité de commande diagnostique qu'un défaut de court-circuit s'est produit au niveau d'au moins l'une de la pluralité de cellules de batterie.

13. Procédé de diagnostic de batterie comprenant les étapes consistant à :
collecter (S100) des valeurs de mesure de chaque tension de batterie, qui est une tension entre les deux bornes d'une batterie, et d'un courant de batterie, qui est le courant circulant à travers la batterie ;
déterminer (S200) un ensemble d'échantillons en extrayant une pluralité de temps de diagnostic précédents correspondant à un nombre prédéterminé d'échantillons à partir d'un temps de diagnostic prédéterminé lors du diagnostic des défauts de la batterie ;
le procédé de diagnostic de batterie étant **caractérisé par** :
le calcul (S310) d'une moyenne mobile, qui est la moyenne d'une pluralité de valeurs de résistance interne de mesure réelle correspondant à la pluralité de temps de diagnostic appartenant à l'ensemble d'échantillons, respectivement, et le calcul (S300) de valeurs de référence, qui sont des références pour diagnostiquer des défauts de la batterie, sur la base de la moyenne mobile ; et
le diagnostic des défauts (S400) de la batterie en comparant une valeur de résistance interne de mesure réelle correspondant au temps de diagnostic prédéterminé avec les valeurs de référence,
dans lequel, lorsque le nombre de la pluralité extraite de temps de diagnostic précédents est inférieur au nombre prédéterminé d'échantillons, la moyenne mobile est calculée sur la base de la pluralité de valeurs de résistance interne de mesure réelle et de valeurs de résistance interne de test correspondant au nombre prédéterminé d'échantillons, et
à chaque temps de diagnostic, la valeur de résistance interne de mesure réelle est calculée sur la base d'au moins l'une de la tension de batterie et du courant de batterie, et les valeurs de résistance interne de test sont déterminées selon un critère prédéterminé.

14. Procédé de diagnostic de batterie selon la revendication 13, dans lequel
les valeurs de référence incluent un seuil de bande supérieure plus grand que la moyenne mobile d'une valeur prédéterminée, et un seuil de bande inférieure plus petit que la moyenne mobile d'une valeur prédéterminée.

15. Procédé de diagnostic de batterie selon la revendication 14, dans lequel
le calcul des valeurs de référence (S300) inclut en outre :
le calcul (S320) d'une valeur d'erreur en multipliant une moyenne d'écart-type qui est la moyenne d'une pluralité d'écarts-types de mesure réelle correspondant à la pluralité de temps de diagnostic, respectivement, par un multiple prédéterminé, et
le calcul (S330) du seuil de bande supérieure en ajoutant la valeur d'erreur à la moyenne mobile, et
le calcul (S330) du seuil de bande inférieure en soustrayant la valeur d'erreur de la moyenne mobile.

16. Procédé de diagnostic de batterie selon la revendication 15, dans lequel
le calcul des valeurs de référence (S300) inclut en outre le calcul de la moyenne d'écart-type sur la base d'écarts-types de mesure réelle et d'écarts-types de test correspondant au nombre prédéterminé d'échantillons, lorsque le nombre de la pluralité extraite de temps de diagnostic précédents est inférieur au nombre prédéterminé d'échantillons, et
à chaque temps de diagnostic, l'écart-type de mesure réelle est calculé sur la base de la pluralité de valeurs de résistance interne de mesure réelle correspondant au nombre prédéterminé d'échantillons, et
les écarts-types de test sont déterminés selon un critère prédéterminé.

17. Procédé de diagnostic de batterie selon la revendication 15, dans lequel
le calcul des valeurs de référence (S300) inclut en outre le calcul de la moyenne mobile sur la base des valeurs de résistance interne de test correspondant au nombre prédéterminé d'échantillons lorsque la pluralité de temps de diagnostic précédents n'existe pas.

18. Procédé de diagnostic de batterie selon la revendication 14, dans lequel
le diagnostic des défauts de la batterie inclut le diagnostic qu'un défaut de déconnexion s'est produit au niveau d'au moins l'une d'une pluralité de cellules de batterie incluses dans la batterie, lorsque la valeur de résistance interne de mesure réelle calculée à chaque temps de diagnostic dépasse le seuil de bande supérieure.

19. Procédé de diagnostic de batterie selon la revendication 14, dans lequel
le diagnostic des défauts (S400) de la batterie inclut le diagnostic (S440) qu'un défaut de court-circuit s'est produit au niveau d'au moins l'une d'une pluralité de cellules de batterie incluses dans la batterie, lorsque la valeur de résistance interne de mesure réelle calculée à chaque temps de diagnostic est inférieure au seuil de bande inférieure.
